# EUROPÄISCHE PATENTSCHRIFT

(11) **EP 2 675 032 B1**
(45) Veröffentlichungstag und Bekanntmachung des Hinweises auf die Patenterteilung: **14.10.2015**
(21) Anmeldenummer: 13165586.2
(22) Anmeldetag: 26.04.2013
(51) Int. Cl.: H02H 9/04, G01R 31/28

(54) **Überspannungsschutzgerät und Diagnoseverfahren für mehrstufige Überspannungsschutzgeräte**
Excess voltage protection device and diagnostic method for multi-stage surge protection devices
Appareil de protection contre les surtensions et procédé de diagnostic pour des appareils de protection contre les surtensions à plusieurs étages

(43) Veröffentlichungstag der Anmeldung: 18.12.2013
(73) Patentinhaber: Pepperl & Fuchs GmbH, 68307 Mannheim (DE)
(72) Erfinder: Beutel, Micha, 55232 Alzey (DE)
(74) Vertreter: Schiffer, Axel Martin

(56) Entgegenhaltungen:
- WO-A1-2008/124587
- DE-A1-102009 004 673

## Beschreibung

Die vorliegende Erfindung betrifft in einem ersten Gesichtspunkt ein Diagnoseverfahren für mehrstufige Überspannungsschutzgeräte nach dem Oberbegriff des Anspruchs 1 und in einem zweiten Gesichtspunkt ein Überspannungsschutzgerät nach dem Oberbegriff des Anspruchs 10, mit welchem insbesondere das erfindungsgemäße Diagnoseverfahren durchgeführt werden kann.

Überspannungsschutzgeräte der im Oberbegriff des Anspruchs 10 bezeichneten Art sind, beispielsweise aus DE 10 2009 004 673 A1 bekannt, und weisen folgende Komponenten auf: einen Eingang und einen Ausgang, mindestens eine Gasentladungsstrecke zwischen dem Eingang und einem Bezugspotenzial als erste Stufe und mindestens eine Diodenstrecke zwischen dem Ausgang und dem Bezugspotenzial als zweite Stufe. Solche Überspannungsschutzgeräte dienen dazu, Überspannungsereignisse, die zwischen dem Eingang und dem Bezugspotenzial auftreten, von einem elektrischen Gerät, das zwischen dem Ausgang und dem Bezugspotenzial angeschlossen sind, fernzuhalten. Die Gasentladungsstrecke wird auch als erste Stufe und die Diodenstrecke auch als zweite Stufe bezeichnet. Deshalb werden Überspannungsschutzgeräte dieser Art als zweistufige Überspannungsschutzgeräte bezeichnet.

Eine allgemeine Aufgabenstellung besteht bei solchen Überspannungsschutzgeräten darin, dass nach einem oder mehreren Überspannungsereignissen entschieden werden muss, ob das Überspannungsschutzgerät noch arbeitsfähig oder schon defekt ist und demgemäß entweder vollständig ausgetauscht werden muss oder jedenfalls Teile des Überspannungsschutzgeräts ausgetauscht werden müssen. Hierzu sind möglichst genaue Informationen über den Zustand der in dem Überspannungsschutzgerät eingesetzten Komponenten notwendig.

In diesem Zusammenhang gibt es im Stand der Technik bereits einige Lösungsansätze, die jedoch jeweils verbesserungsfähig erscheinen. Zunächst kann eine Gehäuseinnentemperatur und/oder eine Temperatur auf der Diode oder den Dioden, welche die Diodenstrecke bilden, mit einer oder mehreren Temperatursicherungen überwacht werden. Sodann kann ein Ansprechen der Diodenstrecke nachgewiesen werden, indem ein Spannungsabfall über die Dioden mit einem oder mehreren Optokopplern nachgewiesen wird. Weiterhin kann das Ansprechen des Gasableiters oder der Gasableiter, welches als Aufblitzen wahrnehmbar ist, mit Fotodioden detektiert werden. Schließlich kann auch ein Spitzenwert des insgesamt abgeleiteten Stroms gemessen werden.

Nun erlauben diese Lösungsansätze bereits Rückschlüsse über den Zustand der verwendeten Komponenten. Diese Rückschlüsse lassen aber im Hinblick auf ihre Eindeutigkeit zu wünschen übrig. Außerdem liefern einige der genannten Überwachungsverfahren nicht in jedem Fall eines Überspannungsereignisses eine nützliche Information. Beispielsweise können relevante Informationen mit Temperatursicherungen nur dann erhalten werden, wenn infolge der Beanspruchung oder eventuell Zerstörung der Schutzelemente eine ausreichend große Leistung im Gerät umgesetzt wird, damit eine Schwellentemperatur der Temperatursicherungen überhaupt erreicht wird. Das ist für viele, in der Mess-, Steuer- und Regeltechnik auftretende Fälle nicht der Fall, insbesondere nicht bei 4 bis 20 mA-Kreisen oder Thermoelementen.

Bei Verwendung von Optokopplern an der Diodenstrecke kann nicht detektiert werden, ob der nachgewiesene Puls die Dioden beschädigt oder gar zerstört hat. Über den Zustand der Gasentladungsstrecke erhält man dabei überhaupt keine Information.

Schließlich liefert auch das Feststellen eines Spitzenwerts des insgesamt abgeleiteten Stroms keinerlei Erkenntnisse über den Zustand der Komponenten der Diodenstrecke.

Aus WO 2008/124587 A1 ist ein Überspannungsgerät mit einer Entkopplungsinduktivität bekannt.

Als eine **Aufgabe** der vorliegenden Erfindung kann deshalb angesehen werden, ein Diagnoseverfahren für zweistufige Überspannungsschutzgeräte sowie ein zweistufiges Überspannungsschutzgerät der oben angegebenen Art zu schaffen, bei denen eine Wartungs- und Fehleranzeige für zweistufige Überspannungsschutzgeräte geliefert wird und wobei im Vergleich zum Stand der Technik deutlich mehr Information über die in dem Überspannungsschutzgerät eingesetzten Komponenten erhältlich ist.

Diese Aufgabe wird durch das Verfahren mit den Merkmalen des Anspruchs 1 gelöst.

In vorrichtungsmäßiger Hinsicht wird die Aufgabe durch das Überspannungsschutzgerät mit den Merkmalen des Anspruchs 10 gelöst.

Bevorzugte Ausführungsbeispiele des erfindungsgemäßen Überspannungsschutzgeräts und vorteilhafte Varianten des erfindungsgemäßen Diagnoseverfahrens werden im Folgenden, insbesondere im Zusammenhang mit den abhängigen Ansprüchen und den Figuren, erläutert.

Das Diagnoseverfahren der oben genannten Art ist erfindungsgemäß dadurch weitergebildet, dass das Überspannungsschutzgerät mindestens eine zwischen dem Eingang und dem Ausgang geschaltete Entkopplungsinduktivität aufweist und dass eine an einer Sekundärinduktivität, die mit der Entkopplungsinduktivität in einer induktiven Wirkungsverbindung steht, anliegende Sekundärspannung gemessen und im Hinblick auf Überspannungsereignisse ausgewertet wird.

Das Überspannungsschutzgerät der oben genannten Art ist erfindungsgemäß dadurch weitergebildet, dass mindestens eine zwischen dem Eingang und dem Ausgang geschaltete Entkopplungsinduktivität vorhanden ist, dass eine Sekundärinduktivität vorhanden ist, die mit der Entkopplungsinduktivität in einer induktiven Wirkungsverbindung steht, und dass eine Auswerteeinheit vorhanden ist, die mit der Sekundärinduktivität verbunden ist und zum Auswerten einer an der Sekundärinduktivität anliegenden Sekundärspannungen eingerichtet ist.

Als eine Grundidee der Erfindung kann angesehen werden, die Entkopplungsinduktivität mit Hilfe einer geeignet positionierten Sekundärinduktivität zu einem induktiven Übertrager zu ergänzen. Dadurch wird ein direkter diagnostischer Zugriff auf Ströme und Spannungen innerhalb des Überspannungsschutzgeräts ermöglicht. Als geeignet wird hierbei eine Anordnung bezeichnet, bei der sich die Sekundärinduktivität mit der Entkopplungsinduktivität in induktiver Wirkverbindung befindet.

Insbesondere können mit Hilfe des erfindungsgemäßen Überspannungsschutzgeräts und des erfindungsgemäßen Verfahrens genaue Informationen darüber erhalten werden, ob das Überspannungsschutzgerät insgesamt in einem guten Zustand, schon häufig beansprucht oder aber defekt ist.

Für die Diodenstrecke können prinzipiell Zener-Dioden verwendet werden. Wegen der steileren Kennlinien und des höheren Ableitvermögens werden jedoch bevorzugt Suppressordioden, die auch als TVS-Dioden bezeichnet werden, verwendet. Die Diodenstrecke kann auch mehrere Dioden aufweisen, die insbesondere in Reihe und/oder parallel geschaltet sein können.

Die Gasentladungsstrecke weist mindestens einen Gasableiter auf, kann grundsätzlich aber auch aus mehreren Gasableitern bestehen, die insbesondere in Reihe und/oder parallel geschaltet sein können.

Anordnungen mit mehreren Dioden und/oder mehreren Gasableitern können als mehrstufige Diodenstrecken oder mehrstufige Gasentladungsstrecken bezeichnet werden.

Die Entkopplungsinduktivität und die Sekundärinduktivität können jeweils mehrere Einzelspulen aufweisen.

Das Bezugspotenzial kann grundsätzlich jedes Potenzial sein. Zweckmäßig wird als Bezugspotenzial das Massepotenzial gewählt.

Bei einer ersten bevorzugten Variante des erfindungsgemäßen Verfahrens wird eine Anzahl der Zündereignisse gezählt und nach einer festzulegenden Anzahl von Zündereignissen wird eine Wartungsaufforderung ausgegeben. In der Auswerteeinheit des erfindungsgemäßen Überspannungsschutzgeräts kann hierzu ein Doppelflankendetektor gebildet sein, mit welchem geprüft wird, ob in einem festgelegten Zeitintervall eine ansteigende und eine abfallende Flanke auftreten, wobei ein solches Ereignis dann als Zündereignis gewertet und gezählt wird. Als Zündereignis wird ein Überspannungsereignis bezeichnet, bei dem eine Gasentladung stattfindet.

Weil bei solchen Zündereignissen der Widerstand über die Diodenstrecke vemachlässigbar ist, entspricht die an der Sekundärinduktivität anliegende Sekundärspannung im Wesentlichen der Spannung über der Gasentladungsstrecke. Der Doppelflankendetektor kann deshalb bei dem erfindungsgemäßen Überspannungsschutzgerät einfach den zeitlichen Verlauf der Sekundärspannung auswerten.

Die Zündvorgänge in der Gasentladungsstrecke unterscheiden sich quantitativ dadurch, dass die Spannung über der Gasentladungsstrecke umso höher ansteigt, je steiler die Anstiegsflanke ist. Durch Bestimmen eines Maximalwerts der Sekundärspannung kann demgemäß ein wichtiger Parameter eines Zündereignisses bestimmt werden.

Ein weiterer bedeutsamer Parameter in diesem Zusammenhang ist das Maximum einer Zeitableitung der Sekundärspannung, weil dieses Maximum, das auch als Flankensteilheit bezeichnet werden kann, ebenfalls charakteristisch für ein bestimmtes Zündereignis ist. Auch die Bestimmung des Maximums der zeitlichen Ableitung der Sekundärspannung kann mit dem erfindungsgemäßen Überspannungsschutzgerät bestimmt werden. Eine wichtige Weiterbildung des erfindungsgemäßen Verfahrens besteht deshalb darin, eine zeitliche Ableitung der Sekundärspannung zu bestimmen, um sodann einen Maximalwert dieser zeitlichen Ableitung der Sekundärspannung zu ermitteln.

Eine nützliche Größe ist außerdem die sogenannte dynamische Ansprechspannung. Hierbei handelt es sich um den Quotienten des Maximalwerts der Zeitableitung der Sekundärspannung und des Maximalwerts der Sekundärspannung. Bei einer weiteren besonders vorteilhaften Variante des erfindungsgemäßen Verfahrens wird demgemäß ein Quotient des Maximalwerts der Zeitableitung der Sekundärspannung und des Maximalwerts der Sekundärspannung selbst gebildet, dieser Quotient wird mit der dynamischen Ansprechspannung gemäß Spezifikation des Gasableiters verglichen und es wird ein Signal erzeugt, wenn der Quotient nicht spezifikationsgemäß ist. Wenn der letzte Fall eintritt, bedeutet das, dass das Überspannungsschutzgerät ausgetauscht werden muss.

Die bisher erläuterten Verfahrensvarianten des erfindungsgemäßen Diagnoseverfahrens liefern Informationen über die Gasentladungsstrecke. Es sind aber auch Auswertungen möglich, bei denen präzise Informationen über die Diodenstrecke erhalten werden können.

Beispielsweise kann das erfindungsgemäße Diagnoseverfahren, um eine Größe zu erhalten, die zu einer der, insbesondere im Verlauf des Überspannungs- oder Zündereignisses, in die Diodenstrecke eingetragene Energie proportional ist, vorteilhaft dadurch ergänzt werden, dass in einem ersten Schritt ein Zeitintegral über die Sekundärspannung gebildet wird, dass in einem zweiten Schritt ein Betrag dieses Zeitintegrals gebildet wird und dass in einem dritten Schritt ein Zeitintegral dieses Betrags gebildet wird. Diese Auswertung kann in der erfindungsgemäß vorgesehenen Auswerteeinheit einfach durchgeführt werden. Diese Weiterbildung des Verfahrens beruht auf Folgendem: Das Integrieren der Sekundärspannung liefert eine Spannung, die proportional zum Strom durch die Primärspule und, weil der Strom durch das angeschlossene zu schützende Gerät im Vergleich zu dem Strom, der über die Diodenstrecke fließt, vernachlässigbar ist, auch zum Strom durch die Diodenstrecke proportional ist. Von dieser Spannung wird sodann der Betrag gebildet und es wird ein weiteres Mal integriert, wodurch man eine Spannung erhält, die proportional zu der in die Diodenstrecke, insbesondere über den Verlauf des Überspannungsereignisses oder Zündereignisses, eingetragenen Energie ist.

Die eigentlich interessierende tatsächliche Temperatur einer die Diodenstrecke bildenden Suppressordiode kann bei einer weiteren vorteilhaften Variante des erfindungsgemäßen Verfahrens erreicht werden, bei der eine Temperaturerhöhung in der Diodenstrecke dadurch ermittelt wird, dass eine Energieabgabe der Diodenstrecke nach außen, beispielsweise durch einen Hochpass, modelliert wird, und dass eine Temperatur der Diodenstrecke durch Addieren der Umgebungstemperatur bestimmt wird.

Die so erhaltene Temperatur kann dann mit einer Zerstörungstemperatur der Diode, beispielsweise also der Suppressordiode, gemäß Datenblatt, verglichen werden. Wenn die Zerstörungstemperatur einmal überschritten wird, wird zweckmäßig von der Zerstörung der Diode oder des ganzen Geräts ausgegangen und dies wird zweckmäßig nach außen angezeigt.

Das hier beschriebene Verfahren und insbesondere die Kernidee, eine Entkopplungsaktivität mit einer Sekundärinduktivität zu einem induktiven Übertrager zu ergänzen und die daran abfallende Sekundärspannung zu messen und auszuwerten, lassen sich auch auf Überspannungsschutzgeräte mit mehreren zu schützenden Leitungspfaden oder differenziellen Aderpaaren erweitern. Es werden dann mehrere Übertrager benötigt und die vorhandenen Zweigströme und Knotenspannungen müssen in grundsätzlich bekannter Weise unter Berücksichtigung der Kirchhoffschen Regeln ermittelt werden.

Weitere Vorteile und Merkmale der erfindungsgemäßen Vorrichtung werden im Folgenden mit Bezug auf die beigefügten Figuren 1 bis 5 erläutert. Hierin zeigen:
- Fig. 1:: in schematischer Ansicht ein Ausführungsbeispiel des erfindungsgemäßen Überspannungsschutzgeräts;
- Fig. 2:: typische zeitliche Verläufe der Spannung über die Gasentladungsstrecke bei verschiedenen Überspannungsereignissen;
- Fig. 3:: zeitliche Verläufe des Stroms durch die Diodenstrecke entsprechend den zeitlichen Verläufen der Spannung über die Gasentladungsstrecke aus Fig. 2;
- Fig. 4:: zeitliche Verläufe des Stroms durch die Gasentladungsstrecke für die in Fig. 2 gezeigten zeitlichen Verläufe der Spannung über die Gasentladungsstrecke; und
- Fig. 5:: in schematischer Ansicht Auswertungsmöglichkeiten der Sekundärspannung mit Hilfe der Auswerteeinheit.

Gleich oder gleichwirkende Komponenten sind in den Figuren in der Regel mit denselben Bezugszeichen gekennzeichnet.

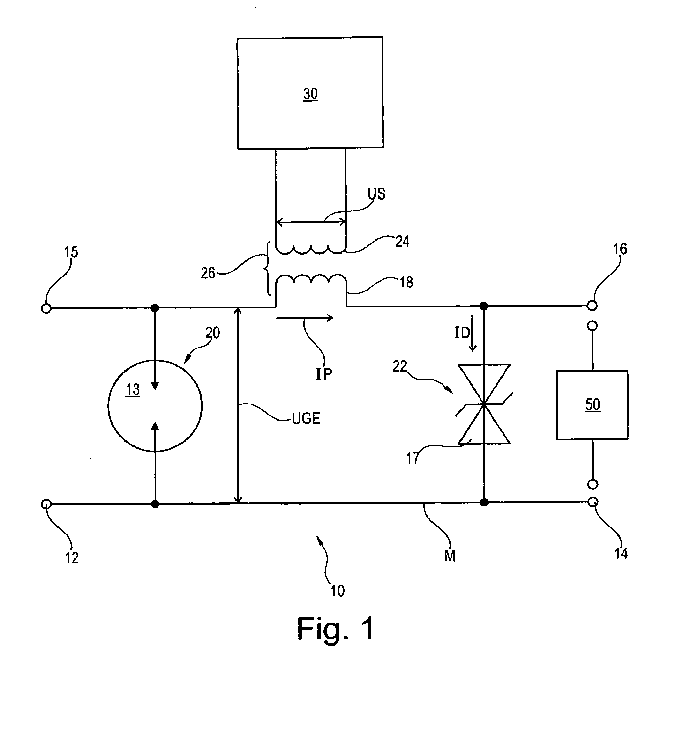

Fig. 1 zeigt ein Ausführungsbeispiel eines erfindungsgemäßen zweistufigen Überspannungsschutzgeräts 10, das als wesentliche Komponenten eine Gasentladungsstrecke 20 und eine Diodenstrecke 22 aufweist. Die Gasentladungsstrecke 20 ist im gezeigten Beispiel aus einem einzigen Gasableiter 13 gebildet und zwischen einem Eingang 15 und einem eingangsseitigen Anschluss 12 für ein Bezugspotenzial M geschaltet. Eine an dem Gasableiter 13 anliegende Spannung ist mit einem Doppelpfeil UGE symbolisiert. Die Diodenstrecke 22 ist im dargestellten Beispiel durch eine einzige Suppressordiode 17 verwirklicht, die zwischen einem Ausgang 16 des Überspannungsschutzgeräts 10 und einem ausgangsseitigen Anschluss 14 für das Bezugspotenzial M geschaltet ist. So wie die Gasentladungsstrecke 20 auch mehrere Gasableiter 13 aufweisen kann, kann auch die Diodenstrecke 22 aus mehreren Dioden, insbesondere Suppressor- oder TVS-Dioden, bestehen. Ein Strom durch die Diodenstrecke 22 ist in Fig. 1 durch einen Pfeil ID dargestellt.

Der Eingang 15 und der Ausgang 16 sind über eine Entkopplungsinduktivität 18 miteinander verbunden. Ein Strom durch diese Entkopplungsinduktivität ist mit einem Pfeil IP gekennzeichnet.

Die Anordnung und Verschaltung der bisher beschriebenen Komponenten ist aus dem Stand der Technik, beispielsweise DE 10 2009 004 673 A1, bekannt.

Eine wichtige Grundidee der vorliegenden Erfindung ist nun, wie in Fig. 1 dargestellt, in unmittelbarer Nähe der Entkopplungsinduktivität 18 eine Sekundärinduktivität 24 so zu positionieren, dass zwischen der Entkopplungsinduktivität 18 und der Sekundärinduktivität 24 eine induktive Wirkungsverbindung besteht und durch diese beiden Komponenten deshalb ein induktiver Übertrager, in Fig. 1 durch die geschweifte Klammer 26 gekennzeichnet, verwirklicht wird. Die Sekundärinduktivität 24, die auch als Sekundärspule bezeichnet werden kann, kann mit einem Mittelabgriff ausgeführt werden, der auf ein Bezugspotenzial gelegt werden kann. Das Gleichrichten der Sekundärspannung ist dann einfacher. Eine über die Sekundärinduktivität 24 abfallende Sekundärspannung ist in Fig. 1 mit dem Doppelpfeil US gekennzeichnet. Diese Sekundärspannung, also die beiden Anschlüsse der Sekundärinduktivität 24, werden einer erfindungsgemäß vorhandenen Auswerteeinheit 30 zugeführt, in welcher die Sekundärspannung US im Hinblick auf Überspannungsereignisse in dem Überspannungsschutzgerät ausgewertet wird.

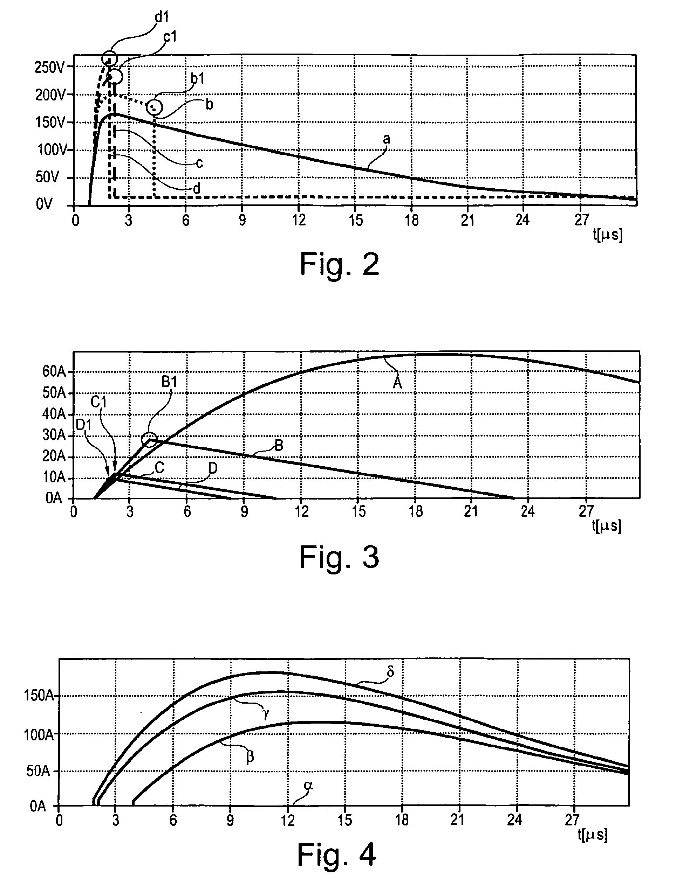

Für Überspannungsschutzgeräte der in Fig. 1 gezeigten Art können Überspannungsereignisse prinzipiell in zwei Gruppen unterteilt werden. Zum einen gibt es Überspannungsereignisse, bei denen der Gasableiter 13 zündet. Bei solchen Ereignissen, die auch als Zündereignisse bezeichnet werden können, wird ein Großteil des Stromstoßes über den Gasableiter 13 abgeleitet. Sodann gibt es Überspannungsereignisse, bei denen der Gasableiter 13 nicht zündet. Bei diesen Ereignissen fließt der Stoßstrom vollständig über die Entkopplungsinduktivität 18 und die Diodenstrecke, beispielsweise also eine einzige Suppressordiode oder eine einzige ZVS-Diode, ab. Dies wird im Zusammenhang mit den Figuren 2 und 4 näher erläutert.

Fig. 2 zeigt die an dem Gasableiter 13 anliegende Spannung UGE. Wie aus Fig. 2 ersichtlich, weisen die Verläufe b, c und d zu unterschiedlichen Zeitpunkten b1, c1 und d1 jeweils äußerst stark abfallende Flanken auf. Hierbei handelt es sich jeweils um die Zeitpunkte, in denen die Gasentladung beginnt, der Gasableiter 13 also durchbricht. Bemerkenswert ist hierbei, dass die Spannungsverläufe vor den Zeitpunkten b1, c1 und d1 jeweils unterschiedliche Verläufe aufweisen, und zwar steigt die Spannung über die Gasentladungsstrecke 20 umso weiter an, je schneller sie ansteigt. Bei einer steilen Anstiegsflanke, wie beispielsweise bei dem Verlauf d, wird mit anderen Worten ein höherer Maximalwert der Spannung UGE erreicht, als bei weniger steilen Anstiegen, beispielsweise Verlauf b. Der Verlauf c liegt in dieser Hinsicht zwischen b und d. Festzustellen ist außerdem, dass bei dem Verlauf a keine stark abfallende Flanke vorhanden ist, was darauf schließen lässt, dass bei a keine Gasentladung stattfindet.

In Fig. 3 sind die zu den Spannungsverläufen a, b, c und d in Fig. 2 gehörenden Diagramme der zeitlichen Verläufe A, B, C beziehungsweise D des Stroms über die Diodenstrecke dargestellt. Zunächst stellt man hierbei fest, dass für den Fall des Spannungsverlaufs a in Fig. 2 der zeitliche Verlauf des Stroms über die Diodenstrecke 50, in Fig. 3 durch die Kurve A dargestellt, über etwa 18µs bis auf einen Maximalwert von knapp 70 Ampere ansteigt und im Anschluss wieder abfällt. Der zeitliche Verlauf des Stroms gemäß Kurve A gehört zu einem Überspannungsereignis, bei dem die Gasentladungsstrecke 20 nicht durchbricht. Die Kurve A weist keine Unstetigkeiten auf und unterscheidet sich hierin grundlegend von den weiteren in Fig. 3 dargestellten zeitlichen Verläufen des Stroms über die Diodenstrecke 50, B, C und D. Bei den Kurven B, C und D fällt auf, dass die Steigung, mit der der Strom über die Diodenstrecke 50 anwächst, umso größer ist, je rascher die an dem Gasableiter 13 anliegende Spannung UGE ansteigt. Sodann ist festzustellen, dass in den Zeitpunkten b1, c1 und d1, in denen die Spannungen über dem Gasableiter 13 zusammenbricht (siehe Fig. 2), jeweils Zeitpunkte B1, C1 und D1 gehören, in denen die zeitlichen Verläufe B, C und D des Stroms über die Diodenstrecke 50 nach unten zu niedrigeren Stromwerten abknicken. Nach diesem Abknicken fallen die Kurven B, C und D mit etwa gleicher negativer Steigung ab. Schließlich ist aus Fig. 3 ersichtlich, dass der maximale durch die Diodenstrecke 50 fließende Strom umso größer ist, je später der Gasableiter 13 durchbricht.

Fig. 4 zeigt die zu den Spannungsverläufen a bis d in Fig. 2 gehörenden Diagramme der entsprechenden Stromverläufe. Weil für den Verlauf a in Fig. 2 keine Gasentladung stattfindet, fließt in dieser Situation über die Gasentladungsstrecke 20 auch kein Strom. Der Verlauf α in Fig. 4, der zum Verlauf a in Fig. 2 gehört, fällt deshalb auf die Nulllinie. Sodann sind in Fig. 4 die Stromverläufe β, γ und δ dargestellt, die zu den Spannungsverläufen b, c beziehungsweise d in Fig. 2 gehören. Dabei ist festzustellen, dass der Strom in glatter Kurve jeweils auf einen Maximalwert ansteigt und dann im weiteren Verlauf im Vergleich zu dem Anstieg langsamer wieder abfällt. Außerdem zeigt sich, insoweit konsistent mit den in Fig. 2 gezeigten Spannungsverläufen, dass der Maximalwert des Stroms, der jeweils von den Kurven β, γ und δ erreicht wird, umso größer ist, je größer auch der Maximalwert der Spannung über die Gasentladungsstrecke 20 ist. Schließlich setzt der Stromanstieg jeweils zu den aus Fig. 2 ersichtlichen Zeitpunkten ein.

Die Überspannungsereignisse, welche die Kurven b/B/β, c/C/γ und d/D/δ liefern, sind also Überspannungsereignisse, bei denen der Gasableiter 13 zündet. Es handelt sich demgemäß um Zündereignisse.

Nur das Ereignis, welches die Kurven a/A/α lieferte, gehört zu der zweiten Gruppe von Überspannungsereignissen, nämlich denjenigen, bei denen der Gasableiter 13 nicht zündet. Bei diesen Ereignissen fließt der Stoßstrom vollständig über die Entkopplungsspule 18 und die Diodenstrecke 22, in der in Fig. 1 dargestellten Situation, also über die Suppressordiode 17 ab. Gleichwohl arbeitet auch bei dem Ereignis a/A/α das erfindungsgemäße Schutzgerät zuverlässig, indem der Stoßstrom über die Entkopplungsinduktivität oder Entkopplungsspule 18 und die Diodenstrecke 50 abgeleitet wird.

Ob der Gasableiter 13 zündet oder nicht, hängt wie erläutert, von der Amplitude, also einem Maximalwert der Spannung, und der Flankensteilheit des Überspannungsimpulses, also einem Maximum einer Zeitableitung der Sekundärspannung, ab.

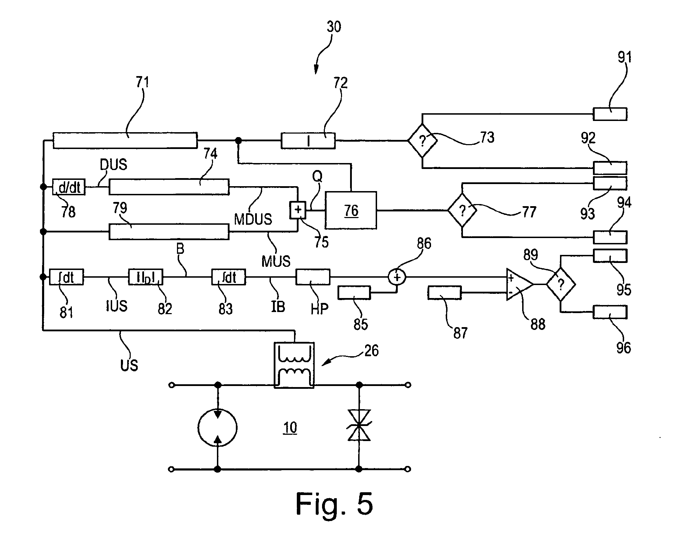

Im Zusammenhang mit Fig. 5 werden nun drei verschiedene Auswertungszweige beschrieben, die jeweils mit Hilfe der erfindungsgemäß vorhandenen Auswerteeinheit 30 durchgeführt werden können. Bei der erfindungsgemäßen Auswerteeinheit kann es sich beispielsweise um einen Mikrocontroller oder eine vergleichbare intelligente Komponente handeln. Allgemein ist, insbesondere bei der folgenden Beschreibung, zu beachten, dass Werte physikalischer Größen, wie Spannungen, Ströme, Temperaturen usw., in der Auswerteschaltung durch Spannungen repräsentiert werden, die zu den jeweiligen physikalischen Größen proportional sind.

Zunächst ist in Fig. 5 schematisch ein erfindungsgemäßes Überspannungsschutzgerät 10 mit dem dort vorhandenen Übertrager 26 gezeigt. Ebenfalls schematisch ist eine Leitung gezeigt, mit welcher die Sekundärspannung US von dem Überspannungsschutzgerät 10 an die erwähnten drei Auswertungszweige geführt wird. Der erste Auswertungszweig generiert Auswertungssignale an den Ausgängen 91 und 92. Der zweite Auswertungszweig generiert Signale an den Ausgängen 93 und 94. Der dritte Auswertungszweig liefert Auswertungssignale an den Ausgängen 95 und 96.

Mit dem Begriff eines Ausgangs soll vorliegend nur zum Ausdruck gebracht werden, dass es sich um einen Ausgang der hier beschriebenen Auswertungszweige handelt. Das bedeutet nicht notwendig, dass diese Ausgänge auch nach außen, beispielsweise an eine Schnittstelle, geführt sind. Dies ist zwar prinzipiell möglich, genauso möglich ist aber, dass die an den Ausgängen 91 bis 96 anstehenden Signale einer weitergehenden internen Verarbeitung zugeführt werden.

Bei dem ersten Auswertungszweig sollen Überspannungsereignisse erkannt werden, bei denen der Gasableiter 13 gezündet hat. Dies erfolgt mit Hilfe eines Doppelflankendetektors 71, der überwacht, ob in einem bestimmten Zeitfenster zwei Spannungsflanken der Sekundärspannung US, eine mit positiver und eine mit negativer Steigung, an der Sekundärinduktivität 24 feststellbar sind. Solche Doppelflanken treten, wie aus Fig. 2 für die Verläufe b, c und d ersichtlich, auf, wenn der Gasableiter 13 infolge einer ausreichend großen Maximalspannung des Überspannungsimpulses zündet. Die Zahl der so ermittelten Zündereignisse werden mit einem Zähler 72 gezählt und in der Abfragestufe 73 mit einem festzulegenden Grenzwert verglichen. Wenn die Zahl der gefundenen Zündereignisse größer ist als der festgelegte Grenzwert, kann eine Wartungsaufforderung signalisiert oder angezeigt werden. Beispielsweise kann am Ausgang 91 ein Signal "Gasableiter abgenutzt" und am Ausgang 92 ein Signal "Gasableiter unverbraucht" ausgegeben werden.

Bei dem zweiten Auswertungszweig wird der Maximalwert MUS der Sekundärspannung US des Übertragers 26, der auch als Spitzenwert der Sekundärspannung US bezeichnet werden kann, ermittelt. Dies erfolgt mit Hilfe eines ersten Spitzenwertdetektors 79, der an seinem Ausgang die genannte maximale Sekundärspannung MUS ausgibt. Außerdem wird in der Einheit 78 eine Zeitableitung DUS der Sekundärspannung US, gebildet, die an einem Ausgang der Einheit 78 bereitgestellt wird. Auch von dieser Zeitableitung DUS wird dann mit Hilfe eines zweiten Spitzenwertdetektors 74 ein Spitzen- oder Maximalwert MDUS gebildet, der dann an einem Ausgang des zweiten Spitzenwertdetektors 74 ausgegeben wird. Dieser Spitzenwert MDUS, wobei es sich wohlgemerkt um eine Spannung handelt, ist proportional zu der maximalen Flankensteilheit der ersten, ansteigenden Flanke. Aus diesen beiden Größen, also der maximalen Sekundärspannung MUS und der maximalen Zeitableitung der Sekundärspannung MDUS wird sodann in der Einheit 75 ein Quotient Q ermittelt. Hierbei handelt es sich um die sogenannte dynamische Ansprechspannung. Die Spannung MUS ist die Ansprechspannung des Gasableiters 13, wenn er gezündet hat. Der Maximalwert der Zeitableitung der Sekundärspannung MDUS entspricht der maximalen Flankensteilheit des Überspannungsimpulses. Die dynamische Ansprechspannung ist also die Ansprechspannung im Verhältnis zur maximalen Flankensteilheit.

Der Quotient Q, also die dynamische Ansprechspannung, wird sodann einer Einheit 76 zugeführt, die den Wert Q nur weiterleitet, wenn ein Zündereignis stattgefunden hat, der Gasableiter 13 also gezündet hat. Diese Information wird der Einheit 76 über den Ausgang des Doppelflankendetektors 71 zur Verfügung gestellt. Wenn es sich um ein Zündereignis gehandelt hat, wird sodann der Quotient Q mit Daten einer Spezifikation verglichen und es wird in der Stufe 77 eine Entscheidung getroffen, ob die dynamische Ansprechspannung Q des Gasableiters 13 noch spezifikationsgemäß ist. Beispielsweise kann am Ausgang 93 ein Signal "Gasableiter defekt" und am Ausgang 94 ein Signal "Gasableiter intakt" ausgegeben werden.

Mit Hilfe des dritten Auswertungszweigs können Informationen über die Diodenstrecke, insbesondere über die besonders wichtige Temperatur der Sperrschicht der Suppressordiode 17, gewonnen werden. Zunächst wird in der Einheit 81 das Zeitintegral IUS der Sekundärspannung US des Übertragers 26 gebildet. Dieses Zeitintegral IUS ist proportional zu dem Strom IP durch die Entkopplungsinduktivität 18 und somit proportional zum Strom durch die Suppressordiode 17, siehe Fig. 1. Das Zeitintegral IUS wird dann einer Einheit 82 zugeführt, welche den Absolutbetrag B des Zeitintegrals IUS bildet. Dieser Betrag wird dann, wie aus Fig. 5 ersichtlich, der Stufe 83 zugeführt, die davon das Zeitintegral IB bestimmt. Dieses Zeitintegral IB ist proportional zu einem Energieeintrag in die Suppressordiode 17 während eines transienten Überspannungsereignisses.

Der Wert IB wird sodann einem Hochpass HP zugeführt, mit welchem das zeitliche Verhalten der thermischen Energieabgabe der Suppressordiode 17, also das Absinken der Temperatur der Suppressordiode 17, modelliert oder simuliert wird. Relevante Mechanismen sind hier Wärmeverlust durch Abstrahlung und Wärmeverlust durch Konvektion. So kann am Ausgang des Hochpasses HP eine Spannung erhalten werden, die zu der Temperaturerhöhung der Sperrschicht der Suppressordiode 17 gegenüber der Umgebung proportional ist.

Über einen Anschluss 85 wird sodann eine Umgebungstemperatur zugeführt und in der Stufe 86 zu der Temperaturerhöhung der Sperrschicht addiert. Man erhält so am Ausgang der Stufe 86 einen Wert für die Temperatur der Sperrschicht der Suppressordiode 17. Diese wird sodann in der Vergleichereinheit 88 mit einer aus einem Datenblatt bekannten Zerstörungstemperatur, die über einen Anschluss 87 dem Vergleicher 88 zugeführt wird, verglichen. An einem Ausgang des Vergleichers 88 wird dann eine Information bereitgestellt, ob die Zerstörungstemperatur der Suppressordiode 17 überschritten wurde oder nicht. Zweckmäßig ist es, von der Zerstörung der Suppressordiode 17 oder auch des ganzen Überspannungsschutzgeräts 10 auszugehen, wenn die Zerstörungstemperatur einmal überschritten wurde. So kann beispielsweise am Ausgang 95 ein Signal "Suppressordiode defekt" und am Ausgang 96 ein Signal "Suppressordiode intakt" ausgegeben werden.

Mit der vorliegenden Erfindung wird ein neuartiges zweistufiges Überspannungsschutzgerät bereitgestellt, welches im Vergleich zum Stand der Technik eindeutige Aussagen ermöglicht, in welchem Zustand sich das Überspannungsschutzgerät befindet und zwar unabhängig von den Eigenschaften eines zu schützenden Stromkreises. Bei dem erfindungsgemäßen Verfahren und dem erfindungsgemäßen Überspannungsschutzgerät werden tatsächliche Bauteilparameter überwacht. Das Verfahren ist unabhängig von den Parametern des zu schützenden elektrischen Geräts. Es kann erkannt werden, ob die Zündspannung des Gasableiters sich noch innerhalb einer Spezifikation befindet. Schließlich kann auch erkannt werden, ob die Suppressordiode oder andere eingesetzte Dioden außerhalb ihrer Spezifikation betrieben wurden und somit von einer Zerstörung auszugehen ist.

## Patentansprüche

1. Diagnoseverfahren für mehrstufige Überspannungsschutzgeräte (10), insbesondere nach Anspruch 10,
die mindestens eine Gasentladungsstrecke (20) zwischen einem Eingang (15) und einem Bezugspotenzial (M) als erste Stufe und
mindestens eine Diodenstrecke (22) zwischen einem Ausgang (16) und dem Bezugspotenzial (M) als weitere Stufe aufweisen,
**dadurch gekennzeichnet,**
**dass** das Überspannungsschutzgerät (10) mindestens eine zwischen dem Eingang (15) und dem Ausgang (16) geschaltete Entkopplungsinduktivität (18) aufweist und
**dass** eine an einer Sekundärinduktivität (24), die mit der Entkopplungsinduktivität (18) in einer induktiven Wirkungsverbindung steht, anliegende Sekundärspannung (US) gemessen und im Hinblick auf Überspannungsereignisse in dem Überspannungsschutzgerät (10) ausgewertet wird.

2. Diagnoseverfahren nach Anspruch 1,
**dadurch gekennzeichnet,**
**dass** geprüft wird, ob in einem festgelegten Zeitintervall eine ansteigende und eine abfallende Flanke der Sekundärspannung (US) auftritt, wobei ein solches Ereignis als Zündereignis bewertet wird.

3. Diagnoseverfahren nach Anspruch 2,
**dadurch gekennzeichnet,**
**dass** eine Anzahl der Zündereignisse ermittelt wird.

4. Diagnoseverfahren nach einem der Ansprüche 1 bis 3,
**dadurch gekennzeichnet,**
**dass** ein Maximalwert (MUS) der Sekundärspannung (US) bestimmt wird.

5. Diagnoseverfahren nach einem der Ansprüche 1 bis 4,
**dadurch gekennzeichnet,**
**dass** eine Zeitableitung (DUS) der Sekundärspannung (US) bestimmt wird.

6. Diagnoseverfahren nach Anspruch 5,
**dadurch gekennzeichnet,**
**dass** ein Maximalwert (MDUS) der Zeitableitung (DUS) der Sekundärspannung (US) bestimmt wird.

7. Diagnoseverfahren nach einem der Ansprüche 5 oder 6,
**dadurch gekennzeichnet,**
**dass** ein Quotient (Q) des Maximalwerts (MDUS) der Zeitableitung (DUS) und des Maximalwerts (MUS) der Sekundärspannung (US) gebildet wird, dass dieser Quotient (Q) mit Werten einer Spezifkation verglichen wird und dass ein Signal erzeugt wird, wenn der Quotient (Q) nicht spezifikationsgemäß ist.

8. Diagnoseverfahren nach einem der Ansprüche 1 bis 7,
**dadurch gekennzeichnet,**
**dass** eine zu einem Energieeintrag in die Diodenstrecke (22), insbesondere während eines Überspannungsereignisses, proportionale Größe ermittelt wird, indem
in einem ersten Schritt ein Zeitintegral (IUS) über die Sekundärspannung (US) gebildet wird,
in einem zweiten Schritt ein Betrag (B) dieses ersten Zeitintegrals (IUS) gebildet wird und
in einem dritten Schritt ein Zeitintegral (IB) dieses Betrags (B) gebildet wird, um so die Größe zu erhalten, die zu der, insbesondere über das Überspannungsereignis, in die Diodenstrecke (22) eingetragenen Energie proportional ist.

9. Diagnoseverfahren nach einem der Ansprüche 8,
**dadurch gekennzeichnet,**
**dass** eine Temperaturerhöhung in der Diodenstrecke (22) ermittelt wird, indem eine Energieabgabe der Diodenstrecke (22) nach außen modelliert wird und dass durch Addition einer Umgebungstemperatur eine Temperatur der Diodenstrecke (22) bestimmt wird.

10. Überspannungsschutzgerät, insbesondere zur Durchführung des Verfahrens nach einem der Ansprüche 1 bis 9,
mit einem Eingang (15) und einem Ausgang (16), wobei zwischen dem Ausgang (16) und einem Bezugspotenzial (M) ein elektrisches Gerät (50) anschließbar ist, das vor Überspannungsereignissen, die zwischen dem Eingang (15) und dem Bezugspotenzial (M) auftreten, zu schützen ist,
mit mindestens einer Gasentladungsstrecke (20) zwischen dem Eingang (15) und dem Bezugspotenzial (M) und
mit mindestens einer Diodenstrecke (22) zwischen dem Ausgang (16) und dem Bezugspotenzial (M),
**dadurch gekennzeichnet,**
**dass** mindestens eine zwischen dem Eingang (15) und dem Ausgang (16) geschaltete Entkopplungsinduktivität (18) vorhanden ist,
**dass** eine Sekundärinduktivität (24) vorhanden ist, die mit der Entkopplungsinduktivität (18) in einer induktiven Wirkungsverbindung steht, und
**dass** eine Auswerteeinheit (30) vorhanden ist, die mit der Sekundärinduktivität (24) verbunden ist und zum Auswerten einer an der Sekundärinduktivität (24) anliegenden Sekundärspannung (US) eingerichtet ist.

## Claims

1. A diagnostic method for multiple-stage excess voltage arresters (10), more particularly those defined in claim 10, which comprise
at least one gas discharge gap (20) between an input (15) and a reference potential (M) as a first stage,
at least one diode path (22) between an output (16) and said reference potential (M) as a further stage, and
**characterized in that**
the excess voltage arresters (10) comprises at least one decoupling inductance (18) interposed between said input (15) and said output (16), and
a secondary voltage (US) present at a secondary inductance (24), which is actively connected, inductively, to said decoupling inductance (18), is measured and evaluated in terms of excess voltage occurrences in the excess voltage arrester (10).

2. The diagnostic method as defined in claim 1,
**characterized in that**
a check is made as to whether an ascending and a descending flank of the secondary voltage (US) occur within a fixed period of time, such an occurrence being evaluated as an ignition event.

3. The diagnostic method as defined in claim 2,
**characterized in that**
the number of ignition events is ascertained.

4. The diagnostic method as defined in any one of claims 1 to 3,
**characterized in that**
a maximum value (MUS) of the secondary voltage (US) is determined.

5. The diagnostic method as defined in any one of claims 1 to 4,
**characterized in that**
a derivative (DUS), with respect to time, of the secondary voltage (US) is determined.

6. The diagnostic method as defined in claim 5,
**characterized in that**
a maximum value (MDUS) of the derivative (DUS), with respect to time, of the secondary voltage (US) is determined.

7. The diagnostic method as defined in claim 5 or claim 6,
**characterized in that**
a quotient (Q) of the maximum value (MDUS) of the derivative (DUS), with respect to time, and the maximum value (MUS) of the secondary voltage (US) is formed,
which quotient (Q) is compared with values of a specification, and
a signal is produced, when said quotient (Q) is not true to specification.

8. The diagnostic method as defined in any one of claims 1 to 7,
**characterized in that**
a parameter proportional to an energy input into the diode path (22), more particularly during an excess voltage occurrence, is ascertained **in that** in a first stage, an integral (IUS), with respect to time, is formed over the secondary voltage (US),
in a second stage, an absolute value (B) of this first integral (IUS), with respect to time, is formed, and
in a third stage, an integral (IB), with respect to time, of said absolute value (B) is formed, in order to obtain the quantity proportional to the energy inputted into the diode path (22), more particularly via the excess voltage occurrence.

9. The diagnostic method as defined in any one of claims 8,
**characterized in that**
an increase in the temperature in said diode path (22) is ascertained **in that** an energy release of said diode path (22) to the outside is modeled and,
by the addition of an ambient temperature, a temperature of the diode path (22) is ascertained.

10. An excess voltage arrester, more particularly for carrying out the method as defined in any one of claims 1 to 9,
comprising an input (15) and an output (16), wherein an electrical device (50) can be connected between said output (16) and a reference potential (M) and which is to be protected from excess voltage occurrences that occur between said input (15) and said reference potential (M),
comprising at least one gas discharge gap (20) between said input (15) and said reference potential (M), and
comprising at least one diode path (22) between said output (16) and said reference potential (M),
**characterized in that**
at least one decoupling inductance (18) is present, interposed between said input (15) and said output (16),
a secondary inductance (24) is present, which is actively connected, inductively, to said decoupling inductance (18), and
that an evaluation unit (30) is present, which is connected to said secondary inductance (24) and is adapted to evaluate a secondary voltage (US) present at said secondary inductance (24).

## Revendications

1. Procédé de diagnostic pour des appareils de protection contre les surtensions (10) à plusieurs étages, tels qu'en particulier selon la revendication 10, qui comprennent :
en tant que premier étage, au moins un chemin de décharge de gaz (20) entre une entrée (15) et un potentiel de référence (M), et
en tant qu'étage suivant, au moins un chemin de diode (22) entre une sortie (16) et le potentiel de référence (M),
**caractérisé :**
**en ce que** l'appareil de protection contre les surtensions (10) comprend au moins un enroulement inductif de découplage (18) connecté entre l'entrée (15) et la sortie (16), et
**en ce qu'**une tension secondaire (US) appliquée au niveau d'un enroulement inductif secondaire (24), qui est placé en relation avec l'enroulement inductif de découplage (18) selon une liaison fonctionnelle inductive, est mesurée et évaluée en prenant en considération les événements de surtension dans l'appareil de protection contre les surtensions (10).

2. Procédé de diagnostic selon la revendication 1,
**caractérisé :**
**en ce qu'**on vérifie si, dans un intervalle de temps prédéterminé, un front montant et un front descendant de la tension secondaire (US) se produisent, un tel événement étant alors évalué comme un événement d'allumage.

3. Procédé de diagnostic selon la revendication 2,
**caractérisé :**
**en ce qu'**un nombre des événements d'allumage est déterminé.

4. Procédé de diagnostic selon une des revendications 1 à 3,
**caractérisé :**
**en ce qu'**une valeur maximale (MUS) de la tension secondaire (US) est déterminée.

5. Procédé de diagnostic selon une des revendications 1 à 4,
**caractérisé :**
**en ce qu'**une dérivée temporelle (DUS) de la tension secondaire (US) est déterminée.

6. Procédé de diagnostic selon la revendication 5,
**caractérisé :**
**en ce qu'**une valeur maximale (MDUS) de la dérivée temporelle (DUS) de la tension secondaire (US) est déterminée.

7. Procédé de diagnostic selon une des revendications 5 ou 6,
**caractérisé :**
**en ce qu'**un quotient (Q) de la valeur maximale (MDUS) de la dérivée temporelle (DUS) et de la valeur maximale (MUS) de la tension secondaire (US) est formé,
**en ce que** ce quotient (Q) est comparé à des valeurs d'une spécification, et
**en ce qu'**un signal est produit si le quotient (Q) n'est pas conforme à la spécification.

8. Procédé de diagnostic selon une des revendications 1 à 7,
**caractérisé :**
**en ce qu'**une grandeur proportionnelle à une production d'énergie dans le chemin de diode (22), en particulier pendant un événement de surtension, est déterminée par le fait que :
dans une première étape, une intégrale temporelle (IUS) est formée à partir de la tension secondaire (US),
dans une deuxième étape, une évaluation (B) de cette première intégrale temporelle (IUS) est formée, et
dans une troisième étape, une intégrale temporelle (IB) de cette évaluation (B) est formée, de manière à obtenir la grandeur qui est proportionnelle à l'énergie produite dans le chemin de diode (22), en particulier pendant l'événement de surtension.

9. Procédé de diagnostic selon une des revendications 8,
**caractérisé :**
**en ce qu'**une élévation de température dans le chemin de diode (22) est déterminée par le fait qu'un dégagement d'énergie du chemin de diode (22) vers l'extérieur est pris comme modèle, et
**en ce que**, par addition d'une température ambiante, une température du trajet de diode (22) est déterminée.

10. Appareil de protection contre les surtensions, en particulier pour la mise en oeuvre du procédé selon une des revendications 1 à 9,
avec une entrée (15) et une sortie (16), un appareil électrique (50) qui est à protéger des événements de surtension qui se produisent entre l'entrée (15) et le potentiel de référence (M) pouvant être alors raccordé entre la sortie (16) et le potentiel de référence (M),
avec au moins un chemin de décharge de gaz (20) entre l'entrée (15) et le potentiel de référence (M), et
avec au moins un chemin de diode (22) entre la sortie (16) et le potentiel de référence (M),
**caractérisé :**
**en ce qu'**au moins un enroulement inductif de découplage (18) connecté entre l'entrée (15) et la sortie (16) est présent,
**en ce qu'**un enroulement inductif secondaire (24), qui est placé en relation avec l'enroulement inductif de découplage (18) selon une liaison fonctionnelle inductive, est présent, et
**en ce qu'**une unité d'exploitation (30) est présente, celle-ci étant connectée à l'enroulement inductif secondaire (24) et adaptée pour l'évaluation d'une tension secondaire (US) appliquée au niveau de l'enroulement inductif secondaire (24).
